# EUROPÄISCHE PATENTSCHRIFT

(11) **EP 3 612 009 B1**
(45) Veröffentlichungstag und Bekanntmachung des Hinweises auf die Patenterteilung: **09.06.2021**
(21) Anmeldenummer: 19187265.4
(22) Anmeldetag: 19.07.2019
(51) Int. Cl.: H05K 3/34, H05K 1/02, H05K 1/03, H05K 3/20

(54) **ELEKTRONIKEINHEIT**
ELECTRONIC UNIT
UNITÉ ÉLECTRONIQUE

(30) Priorität: 24.07.2018 DE 102018212273
(43) Veröffentlichungstag der Anmeldung: 19.02.2020
(73) Patentinhaber: Robert Bosch GmbH, 70442 Stuttgart (DE)
(72) Erfinder: Metais, Benjamin, 73249 Wernau (DE); Sueske, Erik, 72764 Reutlingen (DE); Mueller, Bjoern Jakob, 72074 Tuebingen (DE)

(56) Entgegenhaltungen:
- US-A1- 2005 224 971
- US-A1- 2016 343 915
- US-B1- 6 583 517

## Beschreibung

Die Erfindung betrifft eine Elektronikeinheit sowie ein Verfahren zur Ausbildung der Elektronikeinheit gemäß dem Oberbegriff der unabhängigen Ansprüche.

### Stand der Technik

Grundsätzlich sind Elektronikeinheiten mit immer höheren Leistungen gefragt. Dabei nimmt zukünftig eine über Lebensdauer gesicherte Betriebszuverlässigkeit sowie eine immer weiter komprimierte Bauweise einen wichtigen Stellenwert in der Wettbewerbsfähigkeit derartiger Elektronikeinheiten ein. In vielen Fällen kommen hierfür AMB-Substrate (Active Metal Brazing) zum Einsatz, die beispielsweise einen keramischen Kern aus Si3N4 aufweisen und auf deren Oberseite und/oder Unterseite mittels eines Aktiv-Lotverfahrens eine Dickkupfermetallisierung aufgebracht ist. Die Dickkupfermetallisierung ist hierbei aus thermischer und elektrischer Sicht aufgrund der großen Leistungsströme zwingend erforderlich. In gleicher Weise finden hierzu auch sogenannte DBC-Substrate (Direct Bonded Copper) Verwendung. Auch hier liegt ein keramisches Trägersubstrat vor, deren zumindest eine Substratseite mit einer Dickkupfermetallisierung mittels des ansonsten bekannten DBC-Verfahrens fest verbunden wird. Sowohl AMB-Substrate als auch DBC-Substrate weisen durch die Dickkupfermetallisierung eine hohe elektrische Stromtragfähigkeit und Robustheit auf. Zunehmend kommen aus Fertigungsgründen und/oder wirtschaftlichen Gründen bei Bedarf MLCC-Keramikvielschicht-Chipkondensator (Multi Layer Ceramic Capacitor) für eine elektronische Schaltung zur Anwendung. Allerdings gilt zu beachten, dass diese eine besonders hohe Empfindlichkeit gegenüber mechanischen und/oder thermomechanisch bedingten Krafteinwirkungen aufweisen. Es sind immer wieder Brüche im Aufbau von MLCC-Keramikvielschicht-Chipkondensatoren zu beobachten, die gerade mit Dickkupfermetallisierungen verbunden sind. Allgemein liegt noch kein oder nur ein vages Wissen über einen zugrundeliegenden Versagensmechanismus vor. Die Bruchursachen werden unter anderem dem thermischen Ausdehnungsbestreben des Kupfermateriales zugeschrieben, wobei Vermutungen bestehen, dass dadurch sich innere Spannungszustände im Chipkondensator aufbauen, die bei zu großen Spannungswerten zu einem Bruch führen können. Dadurch wird jedoch die Funktion der Elektronikeinheit gestört oder entfällt im ungünstigsten Fall vollständig. In vielen Fällen werden MLCC-Keramikvielschicht-Chipkondensatoren nur in Verbindung mit einem DBC-Schaltungsträger eingesetzt. Die Gefahr von Brüchen eines MLCC-Keramikvielschicht-Chipkondensators scheint hier zumindest bei geringen Keramiksubstratstärken und reduzierter Schichtdicke der Kupfermetallisierung gebannt, beispielsweise bei einer beidseitig 300 µm dicken Kupfermetallisierung auf einer 635 µm starken Al2O3 Keramik oder bei einer beidseitig 300 µm dicken Kupfermetallisierung und einer 320 µm starken Zirconia Keramik. Eine weitere Verbesserung lässt sich bei DBC-Schaltungsträgers dadurch erreichen, dass im Bereich eines mit einer Kontaktierungsseite des DBC-Schaltungsträgers elektrisch kontaktierten MLCC-Keramikvielschicht-Chipkondensators auf der der Kontaktierungsseite gegenüberliegenden Seite des Schaltungsträgers schachbrettartige Aussparungen in der Kupfermetallisierung eingebracht werden. Auf diese Weise können thermomechanisch bedingte Spannungen im Bereich des kontaktierten MLCC-Keramikvielschicht-Chipkondensators verringert werden. Dagegen zeigen solche Vorkehrungen bei AMB-Schaltungsträger nicht im gleichen Maße oder gar keinen Erfolg, so dass aus Sicherheitsgründen deren Einsatz in Verbindung mit einem MLCC-Keramikvielschicht-Chipkondensator in Frage gestellt ist oder ganz ausgeschlossen ist. Erschwerend kommt hinzu, dass gerade bei AMB-Schaltungsträger das keramische Trägersubstrat und die Kupfermetallisierung einen besonders großen Unterschied in ihren jeweiligen thermischen Ausdehnungskoeffizienten aufweisen. So weist beispielsweise eine Si3N4 Keramik einen thermischen Ausdehnungskoeffizienten von ungefähr 2.6 ppm/K auf, wogegen der thermische Ausdehnungskoeffizient von Kupfer bereits ungefähr 17 ppm/K beträgt. Insgesamt ist dadurch die Auswahl von möglichen Schaltungsträgertypen für Elektronikeinheiten mit hohen Leistungen in Verbindung mit dem Einsatz von MLCC-Keramikvielschicht-Kondensatoren eingeschränkt

Aus dem Stand der Technik sind die Dokumente US-A1-20160343915, US- A1-20050224971, US-B1-6583517 bekannt.

### Offenbarung der Erfindung

### Vorteile

Der Erfindung liegt die Aufgabe zu Grunde, die Verwendung von MLCC-Keramikvielschicht-Chipkondensatoren auf keramischen Schaltungsträger mit einer Si3N4 Keramik betriebssicher innerhalb einer Elektronikeinheit zu ermöglichen.

Diese Aufgabe wird durch eine Elektronikeinheit sowie ein Verfahren zur Ausbildung der Elektronikeinheit gemäß der unabhängigen Ansprüche gelöst.

Ausgegangen wird von einer Elektronikeinheit umfassend zumindest einen Schaltungsträger mit einem keramischen Trägersubstrat aus Si3N4, insbesondere ein AMB (Active Metal Brazing) -Schaltungsträger, wobei das Trägersubstrat eine Ober- und eine Unterseite aufweist und auf der Ober- und/oder Unterseite zumindest eine Leiterstruktur umfassend zumindest eine Schicht aus Kupfer oder einer Kupferlegierung angeordnet ist. Ferner weist die Leiterstruktur eine äußerste Abschlussfläche auf, auf welcher Kontaktierungsstellen ausgebildet sind, die mit Kontaktanschlüssen zumindest eines elektrischen und/oder elektronischen Bauelements unter Ausbildung einer elektronischen Schaltung der Elektronikeinheit elektrisch kontaktiert sind. Die elektronische Schaltung umfasst dabei zumindest einen MLCC-Keramikvielschicht-Chipkondensator (Multi Layer Ceramic Capacitor). Zusätzlich weist die Leiterstruktur zumindest einen gegenüber der äußersten Abschlussfläche vertieften Strukturbereich auf, wobei in dem zumindest einen vertieften Strukturbereich tiefenversetzte Kontaktierungsstellen ausgebildet sind, die dann mit korrespondierenden Kontaktanschlüssen des zumindest einen MLCC-Keramikvielschicht-Chipkondensator elektrisch kontaktiert sind, beispielsweise mittels einer Lot-, Sinter- oder Leitkleberverbindung.

Hausinterne Untersuchungen der Anmelderin zu möglichen Versagensursachen bei einem MLCC-Keramikvielschicht-Chipkondensator in Verbindung beispielsweise mit einem AMB-Schaltungsträger mit einer Si3N4 Keramik legen den Schluss nahe, dass als eine besonders ausschlaggebende Versagensursache die oft bei DBC- und AMB-Schaltungsträger beobachtete Verwölbung - allgemein auch als warpage bekannt - in Richtung der Substratdicke gelten dürfte. Gerade aufgrund des großen Unterschiedes der Ausdehnungskoeffizienten von Kupfer und Si3N4 sind mit zunehmender Dickkupfermetallisierung und mit kleinerer Substratstärke des keramischen Trägersubstrates die außen elektrisch kontaktierten MLCC-Keramikvielschicht-Chipkondensatoren sehr hohen Spannungszuständen ausgesetzt. Durch die vertiefte Anordnung von Kontaktierungsstellen für den MLCC-Keramikvielschicht-Chipkondensator folgt man vorteilhaft der Erkenntnis in der mechanischen Statik, dass bei einem unter Biegung befindlichen mechanischen Systems innenliegende Schichten einen geringeren Spannungszustand aufweisen als die weiter außenliegenden Schichten. Zusätzlich kommt es aufgrund der Materialschwächung im vertieften Strukturbereich lokal zu Materialnachgiebigkeiten, durch welche mechanische bzw. thermomechanische Spannungen weiter abgebaut werden können. Insgesamt ist vorteilhaft erreicht, dass nun selbst bei bisher für eine Verwendung als ungünstig oder unmöglich erachteten keramischen Schaltungsträger mit einem Si3N4 Trägersubstrat die nun im vertieften Strukturbereich elektrisch kontaktierten MLCC-Keramikvielschicht-Chipkondensatoren einer deutlich reduzierteren mechanischen bzw. thermomechanischen Belastung ausgesetzt werden. Dadurch können bisher in diesen Fällen ansonsten auftretende Versagensbrüche wirkungsvoll vermieden werden und eine Funktionssicherheit der Elektronikeinheit sichergestellt werden.

Bevorzugt geht der keramische Schaltungsträger aus einem Ausgangssubstrat hervor, wobei bei diesem an wenigstens einer Oberflächenseite wenigstens eine Außenfläche ausgebildet ist, die durch Aufbringen einer flächig durchgehenden, geschlossenen Metallschicht oder Metallfolie mittels Aktiv-Lot-Verfahrens erzeugt ist. Das Ausgangssubstrat weist demnach vorab keine Leiterstruktur auf. Vielmehr ist diese beim dann vorliegenden keramischen Schaltungsträger aus der ursprünglich durchgehenden, geschlossenen einen Metallschicht oder Metallfolie ausgebildet, insbesondere durch ein - einem Elektroniklayout entsprechend - lokales Entfernen von Material der Metallschicht oder der Metallfolie, beispielsweise einem mechanischen (z.B., Fräsen, Schlitzen), elektrisch physikalischen (z.B. Lasern) und/oder chemischen (z.B. Ätzen) Abtragen. Vorteilhaft weist der vertiefte Strukturbereich damit gleichsam eine hohe Anbindung mit dem Trägersubstrat auf, wie die außerhalb des vertieften Strukturbereichs ausgebildeten Strukturbereiche. Bevorzugt bildet die der Ober- und/oder Unterseite abgewandte Außenfläche der ursprünglich flächig durchgehenden, geschlossenen Metallschicht oder Metallfolie die äußerste Abschlussfläche der außerhalb des vertieften Strukturbereiches ausgebildeten Strukturbereiche. Auf diese Weise kann der keramische Schaltungsträger zeitlich und von den Kosten mit reduziertem Aufwand hergestellt werden. Bevorzugt kommt dabei als das Ausgangssubstrat ein AMB-Substrat zum Einsatz mit einer Schichtdicke der ursprünglich flächig durchgehenden, geschlossenen einen Metallschicht oder Metallfolie von 300 µm bis einschließlich 1500 µm, insbesondere von 300 µm bis einschließlich 1000 µm, vor allem jedoch mit einem in der Branche für einen Serieneinsatz üblichen Standardmaß, beispielsweise mit 300 µm oder 500 µm. Die Leiterstruktur und damit auch die ursprüngliche Metallschicht bzw. Metallfolie des Ausgangssubstrates können dabei auch mehrschichtig vorliegen. Neben der zumindest einen Schicht aus Kupfer oder einer Kupferlegierung sind dann auf dieser weitere metallische Schichten angeordnet, wobei eine letzte angeordnete Schicht die äußerste Abschlussfläche ausbildet. Zumindest eine weitere, mehrere weitere und/oder die letzte Schicht sind bevorzugt als ein Plating aufgebracht, weiter bevorzugt aus Silber, aus Nickel und/oder aus Gold. Andere geeignete Materialien für ein Plating sind ebenso möglich. Das Plating verbessert beispielsweise ein elektrisches Kontaktieren von elektrischen und/oder elektronischen Bauelementen. Zusätzlich wird eine Oxidation von Kontaktoberflächen verhindert. Sie weisen in der Regel nur dünne Schichtstärken auf, beispielsweise 0,1 - 0,5 µm.

In einer bevorzugten Ausführungsform der Elektronikeinheit weist das Trägersubstrat zwischen der Ober- und Unterseite eine Substratstärke von 250 um bis einschließlich 635 um auf und/oder schließt die äußerste Abschlussfläche der Leiterstruktur in einem senkrechten Schnitt zur Ober- und/oder Unterseite mit einem Abschlusshöhenmaß h1 von 300 um - 1000 um ab. In dieser Ausführungsform können eine Vielzahl von Elektronikeinheiten in Hinblick auf deren Erfordernisse einer thermischen und mechanischen Robustheit für große Leistungen realisiert werden und die daraus bedingten mechanischen und/oder thermomechanischen Belastungen für elektrisch kontaktierte MLCC-Keramikvielschicht-Chipkondensatoren trotzdem unterhalb für einen Bruch kritischen Werte gehalten werden. Für diese oder andere Ausführungsformen der Elektronikeinheit ist es für diesen Zweck besonders günstig, wenn der zumindest eine vertiefte Strukturbereich zumindest eine Anschlussfläche umfasst, auf der zumindest eine tiefenversetzte Kontaktierungsstelle ausgebildet ist, wobei die Anschlussfläche in einem senkrechten Schnitt zur Ober- und/oder Unterseite mit einem Anschlusshöhenmaß von 100 µm bis einschließlich 800 µm abschließt. Dabei ist bevorzugt das Anschlusshöhenmaß mindestens 50 um, bevorzugt mindestens 100 um kleiner als das Abschlusshöhenmaß h1. In diesem Höhenbereich treten vorteilhaft unkritische Spannungszustände für den hier elektrisch kontaktierten MLCC-Keramikvielschicht-Chipkondensator auf.

Bei einer bevorzugten Ausführungsform der Elektronikeinheit ist die Leiterstruktur zumindest gebildet aus mehreren direkt benachbarten und über das keramische Trägersubstrat elektrisch voneinander isolierten Strukturarealen, insbesondere in Form von Leiterbahnen und/oder Kontaktanschlusspads, wobei die zumindest eine Anschlussfläche in dem zumindest einen vertieften Strukturbereich gebildet ist auf einem Stufenabsatz, welcher von einem Strukturareal von der äußersten Abschlussfläche abgesetzt ist und mit dem Abschlusshöhenmaß abschließt und/oder auf zumindest einem Strukturareal ausgebildet ist, welches mit einem Anschlusshöhenmaß abschließt. Vorteilhaft ergibt sich durch den Stufenabsatz eine einfache elektrische Verbindungsbrücke zwischen dem vertieften Strukturbereich und einem Strukturbereich der Leiterstruktur, welcher außerhalb des vertieften Strukturbereiches ausgebildet ist. Auf diese Weise sind Schaltungsteile auf unterschiedlichen Höhenebenen elektrisch ohne weitere Verbindungselemente kontaktierbar. Darüber hinaus können aufgrund der reduzierten Höhenerstreckung direkt benachbarte Strukturareale mit dem Anschlusshöhenmaß mit einem verkleinertem Fine-Pitch-Abstandsmaß ausgebildet werden. Gerade MLCC-Keramikvielschicht-Chipkondensator weisen ein solches kleines Anschlussmaß an, welches bei ansonsten in Dickkupfermetallisierungen nur grob möglich ausgebildeter Leiterstruktur nicht oder nur schwer oder sehr kosten- und fertigungsaufwändig zu realisieren ist. Derartige Fine-Pitch-Anschlussmaße sind in der Regel für eine Vielzahl von elektronischen Bauelement aus von Anbietern offengelegten Datenblätter entnehmbar. Damit lassen sich neben den MLCC-Keramikvielschicht-Chipkondensatoren noch andere sehr kleine passive Bauelemente, Logikbauteile und andere elektrische und/oder elektronische Bauelemente zur Ausbildung insbesondere einer Logik- und/oder Ansteuerschaltung im Bereich des vertieften Strukturbereiches elektrisch kontaktieren. Bevorzugt weist der vertiefte Strukturbereich ein Fine-Pitch-Anschlussmaß zwischen zumindest zwei tiefenversetzten Kontaktierungsstellen von 50 um bis einschließlich 600 um auf, insbesondere von 50 um bis einschließlich 300 um.

In Bezug auf die strukturelle Ausführung des vertieften Strukturbereichs lassen sich verschiedene vorteilhafte Variationen zur elektrischen Kontaktierung der Kontaktanschlüsse zumindest eines MLCC-Keramikvielschicht-Chipkondensators vorsehen. So ist besonders günstig durch korrespondierende Kontaktanschlüsse zumindest eines MLCC-Keramikvielschicht-Chipkondensators und mit diesen elektrisch kontaktierten tiefenversetzten Kontaktierungsstellen zumindest eine erste Art von Kontaktanordnung ausgebildet, bei welcher die tiefenversetzten Kontaktierungsstellen auf zwei sich zugewandten direkt benachbarten Stufenabsätzen ausgebildet sind. Dies kann dabei in einer solchen Form erfolgen, dass die zwei mit dem Stufenabsatz gebildeten Strukturareale in einer entsprechenden Linienanordnung oder in einer entsprechenden Parallelanordnung angeordnet sind, in welchen die Stufenabsätze benachbart sind und sich entsprechend zugewandt gegenüberstehen. Eine alternative Variation zeigt sich dadurch, dass eine zweite Art von Kontaktanordnung ausgebildet ist, bei welcher die tiefenversetzten Kontaktierungsstellen auf einem Stufenabsatz und einem direkt benachbarten Strukturareal mit dem Anschlusshöhenmaß ausgebildet sind. Auch hier ist in ähnlicher Weise sowohl eine Linienanordnung als auch eine Parallelanordnung ermöglicht. Eine weitere alternative Variation ist dadurch gegeben, dass eine dritte Art von Kontaktanordnung gebildet ist, bei welcher tiefenversetzte Kontaktierungsstellen auf zweien direkt benachbarten Strukturarealen mit jeweils dem Anschlusshöhenmaß ausgebildet sind. Insgesamt bietet der vertiefte Strukturbereich damit die Möglichkeit, sehr flexibel unterschiedlichste Schaltungstopologien zu realisieren. Ist in einem vertieften Strukturbereich nur ein MLCC-Keramikvielschicht-Chipkondensator elektrisch kontaktiert, so ist bevorzugt für diesen vertieften Strukturbereich ausschließlich nur eine der zuvor genannten Art von Kontaktanordnungen ausgebildet. Sind dagegen zwei oder mehrere in einem vertieften Strukturbereich elektrisch kontaktierte MLCC-Keramikvielschicht-Chipkondensatoren angeordnet, so ist beispielsweise ausschließlich nur eine der zuvor genannten Art von Kontaktanordnung ausgebildet. Alternativ sind das Vorliegen von zumindest zwei unterschiedlichen Arten von Kontaktanordnungen denkbar.

In einer vorteilhaften Weiterbildung der Elektronik sind im vertieften Strukturbereich neben dem zumindest einem MLCC-Keramikvielschicht-Chipkondensator weitere elektrische und/oder elektronische Bauelemente mit zumindest einem Stufenabsatz und/oder mit zumindest einem Strukturareal mit dem Anschlusshöhenmaß unter Ausbildung einer Ansteuerschaltung für eine Leistungsschaltung elektrisch kontaktiert, wobei die Leistungsschaltung elektrische und/oder elektronische Bauelemente umfasst, die zumindest mit den Strukturarealen mit dem Abschlusshöhenmaß elektrisch kontaktiert sind. Sowohl die Ansteuerschaltung als auch die Leistungsschaltung sind dabei jeweils Teil der elektronischen Schaltung der Elektronikeinheit. Vorteilhaft können dadurch beide Schaltungsteile auf dem gleichen Schaltungsträger realisiert werden. Insgesamt ist dies auch besonders günstig dadurch ermöglicht, da im vertieften Strukturbereich eine Feinstrukturierung der Leiterstruktur aufgrund der reduzierten Höhenerstreckung realisierbar ist.

Eine weitere Verbesserung ergibt sich bei einer Ausführungsform der Elektronikeinheit, bei welcher auf der Oberseite und der Unterseite jeweils zumindest ein vertiefter Strukturbereich ausgebildet sind, die zu einer Mittelebene des Trägersubstrats gespiegelt identisch oder weitestgehend strukturell identisch ausgebildet sind. Dies führt aufgrund der zusätzlichen Materialabschwächung zu einem weiteren ermöglichten Spannungsabbau. Zusätzlich kann durch die sich dann genau gegenüberliegende Anordnung gleicher oder ähnlicher vertiefter Strukturbereiche Ursachen einer Verwölbung (warpage) entzogen oder zumindest verringert werden. Es zeigt sich, dass diese günstigen Bedingungen aufrechterhalten werden können, wenn die gespiegelten vertieften Strukturbereiche sich 80% -100%, insbesondere 90% - 100%, in gleich ausgeführten Strukturteilen entsprechen.

Die Erfindung führt auch zu einem Verfahren zur Ausbildung einer Elektronikeinheit nach zumindest einer der zuvor beschriebenen Ausführungsformen, mit den nachfolgenden Verfahrensschritten:
a) Bereitstellen eines keramischen Ausgangssubstrates mit einem keramischen Trägersubstrat aus Si3N4, wobei an wenigstens einer Oberflächenseite des keramischen Trägersubstrates wenigstens eine durchgehend geschlossene metallische Abschlussfläche ausgebildet ist, die durch Aufbringen zumindest einer Metallschicht oder Metallfolie aus Kupfer oder einer Kupferlegierung mittels Aktiv-Lot-Verfahrens erzeugt ist, insbesondere ein AMB-Schaltungsträger, wobei die Abschlussfläche mit dem Abschlusshöhenmaß abschließt,
b) Ausbilden einer Zwischenstufe der Leiterstruktur in der Metallschicht oder Metallfolie auf zumindest einer Oberflächenseite des Trägersubstrates durch einen Ätzprozess, durch welchen zueinander beabstandete metallische Strukturareale mil dem Abschlusshöhenmaß ausgebildet werden, welche über das keramische Trägersubstrat elektrisch voneinander isoliert sind, wobei dann mittels eines gestuften chemischen Ätzprozesses in zumindest einem Strukturareal eine zur Abschlussfläcl abgesetzte Vertiefungsnut ausgebildet wird, die eine oder zwei abstehende Nutseitenflächen und einen Nutgrund mit dem Anschlusshöhenmaß h2 aufweist,
c) Ausbilden einer Endstufe der Leiterstruktur, umfassend zumindest einen vertieften Strukturbereich, indem mittels eines weiteren Ätzprozesses oder mittels eines Laserabtragungsprozesses im Bereich der Vertiefungsnut metallisches Material der Metallschicht oder der Metallfolie bis zur Oberflächenseite des keramischen Trägersubstrates abgetragen wird, so dass zumindest ein Strukturareal mit einem Stufenabsatz, insbesondere zwei Strukturareale mit zueinander zugewandten Stufenabsätzen, und/oder zumindest ein Strukturareal mit jeweils dem Anschlusshöhenmaß als der vertiefte Strukturbereich ausgebildet werden,
d) Elektrisches Kontaktieren von korrespondierenden Anschlusskontakten zumindest eines MLCC-Keramikvielschicht-Chipkondensators mit zumindest einem Stufenabsatz und/oder mit einem Strukturareal mit jeweils dem Anschlusshöhenmaß.

Es sind allgemein gestufte chemische Ätzprozess bekannt. Die Ätzparameter sind insbesondere in Abhängigkeit der Schichtstärke der Metallschicht oder Metallfolie des Ausgangssubstrates festzulegen, um dann unter anderem lokal einen erforderlichen Materialabtrag bis auf das Anschlusshöhenmaß innerhalb des zumindest einen vertieften Strukturbereiches zu ermöglichen. Ähnliches gilt für den Laserabtragungsprozess. Entsprechend einzustellende Laserparameter orientieren sich dabei maßgeblich auf die nach dem Ätzprozess verbliebenen Schichtdicke mit dem Anschlusshöhenmaß. Der Materialabtrag kann hierbei lokal bis mindestens zur Oberflächenseite des keramischen Trägersubstrates auf einmal oder durch einen wiederholten Teilabtrag erfolgen. Besonders effizient erfolgt der Materialabtrag durch einen gepulsten Laserprozess, durch welchen abzutragendes Material aufgrund von Laserpulsen erhitzt und verdampft wird. Hierbei kann eine sehr hohe Laserleistung so fokussiert im Bereich der Metallschicht konzentriert werden, dass eine Beschädigung des keramischen Trägersubstrates vermieden wird.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Fig. 1:: eine beispielhafte Ausführungsform einer Elektronikeinheit umfassend eine beispielhafte Ausführungsform eines vertieften Strukturbereiches innerhalb des keramischen Schaltungsträgers in einer seitlichen Schnittdarstellung,
- Fig. 2a:: eine beispielhafte Ausführungsvariation eines vertieften Strukturbereiches innerhalb des keramischen Schaltungsträgers in einer seitlichen Schnittdarstellung,
- Fig. 2b:: eine weitere beispielhafte Ausführungsvariation eines vertieften Strukturbereiches innerhalb des keramischen Schaltungsträgers in einer seitlichen Schnittdarstellung,
- Fig. 2c:: eine weitere beispielhafte Ausführungsvariation eines vertieften Strukturbereiches innerhalb des keramischen Schaltungsträgers in einer seitlichen Schnittdarstellung,
- Fig. 2d:: eine beispielhafte Ausführungsvariation eines vertieften Strukturbereiches innerhalb des keramischen Schaltungsträgers in einer Draufsicht mit in einer Linienanordnung von Strukturarealen zugewandten Stufenabsätzen,
- Fig. 2e:: eine weitere beispielhafte Ausführungsvariation eines vertieften Strukturbereiches innerhalb des keramischen Schaltungsträgers in einer Draufsicht mit in einer Parallelanordnung von Strukturarealen zugewandten Stufenabsätzen,
- Fig. 3a:: ein Ausgangssubstrat für den keramischen Schaltungsträger aus Fig. 1 in einer seitlichen Schnittdarstellung,
- Fig. 3b:: ein Fertigungszustand des Ausgangssubstrates aus Fig. 3a nach einem Ätzprozess unter Ausbildung einer Zwischenstufe einer Leiterstruktur in einer seitlichen Schnittdarstellung,
- Fig. 3c:: ein fertiggestellter keramischer Schaltungsträger umfassend einen vertieften Strukturbereich nach einem Laser- oder Ätzabtragungsprozess in zuvor geätzen Metallbereichen in einer seitlichen Schnittdarstellung.

### Ausführungsformen der Erfindung

In den Figuren sind funktional gleiche Bauelemente jeweils mit gleichen Bezugszeichen gekennzeichnet.

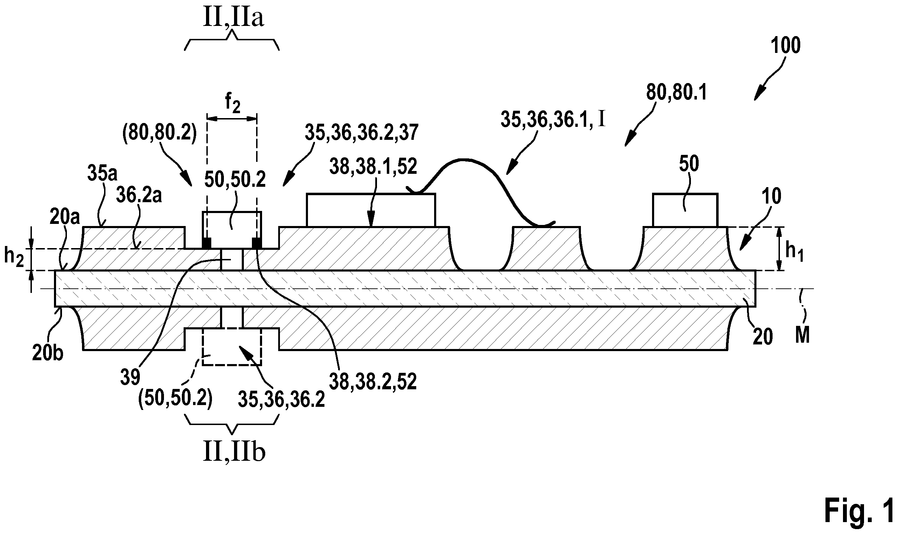

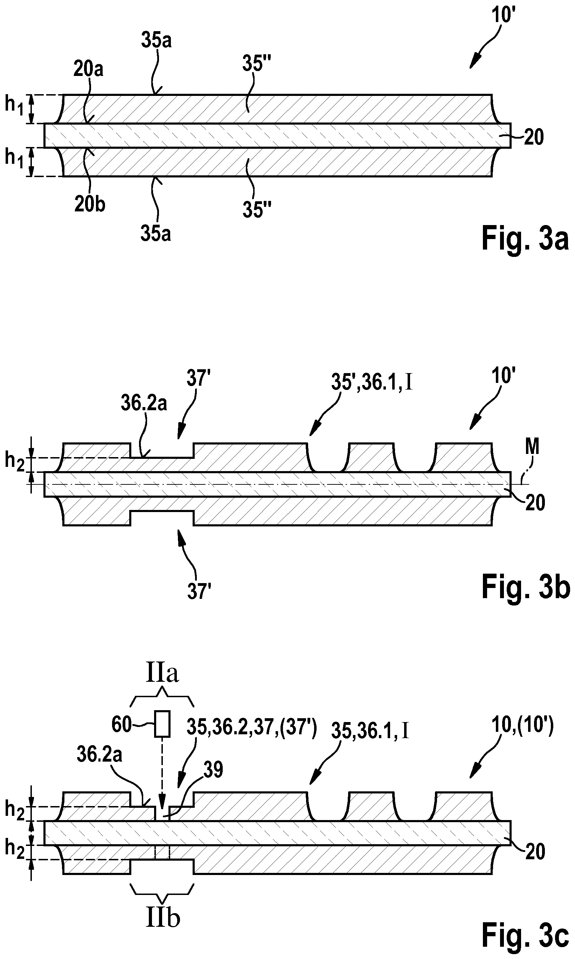

In der Fig. 1 ist eine beispielhafte Ausführungsform einer Elektronikeinheit 100 gezeigt. Diese umfasst eine beispielhafte Ausführungsform eines vertieften Strukturbereiches II innerhalb eines keramischen Schaltungsträgers 10 mit einem Trägersubstrat 20 aus einer Si3N4 Keramik. Bevorzugt handelt es sich dabei um ein AMB-(Active Metal Brazing) Schaltungsträger 10, dessen Herstellung mit Verweis auf die Fig. 3a - 3c noch detailliert beschrieben wird. Das Trägersubstrat 20 weist eine Oberseite 20a und eine Unterseite 20b auf mit jeweils einer Metallisierung 30 umfassend zumindest eine mit der Ober- und/oder Unterseite 20a, 20b verbundenen Schicht aus Kupfer oder einer Kupferlegierung. Darüber hinaus können auf der zumindest einen Schicht aus Kupfer oder einer Kupferlegierung weitere Schichten angeordnet sein, insbesondere als Plating, beispielsweise aus Silber, Nickel und/oder Gold. In diesem Ausführungsbeispiel ist auf der Oberseite 20a des keramisches Trägersubstrates 20 in der Metallisierung 30 eine Leiterstruktur 35 ausgebildet, welche mit einer äußersten Abschlussfläche 35a abschließt. Die Leiterstruktur 35 weist dabei eine Vielzahl benachbarter Strukturareal 36 auf, beispielsweise als Leiterbahnen oder Kontaktanschlusspads, die über das keramische Trägersubstrat 20 elektrisch voneinander isoliert sind. Die Leiterstruktur 35 weist ferner der Oberseite 20a des Trägersubstrates 20 zugewandt zumindest einen vertieften Strukturbereich IIa auf. Im Strukturbereich I außerhalb des vertieften Strukturbereiches IIa schließen die dort ausgebildeten Strukturareale 36.1 in einem senkrechten Schnitt zur Ober- und/oder Unterseite 20a, 20b mit einem Abschlusshöhenmaß h1 ab. Der vertiefte Strukturbereich IIa weist dagegen eine Anschlussfläche 36.2a auf, die gegenüber der äußersten Abschlussfläche 35a zum Trägersubstrat 20 hin vertieft angeordnet ist. Die Anschlussfläche 36.2a schließt dabei in einem senkrechten Schnitt zur Ober- und/oder Unterseite 20a, 20b mit einem Anschlusshöhenmaß h2 ab, welches kleiner ist als das Abschlusshöhenmaß h1. Sowohl die äußerste Abschlussfläche 35a als auch die Anschlussfläche 36.2a innerhalb des vertieften Strukturbereichs IIa weisen dabei Kontaktierungsstellen 38 auf, über welche die Leiterstruktur 35 mit entsprechenden Strukturarealen 36, 36.1, 36.2 mit korrespondierenden Kontaktanschlüssen 52 von elektrischen und/oder elektronischen Bauelementen 50 elektrisch kontaktiert sind. Mittels der Leiterstruktur 35 und der damit elektrisch kontaktierten elektrischen und/oder elektronischen Bauelementen 50 ist insgesamt eine elektronische Schaltung 80 der Elektronikeinheit 100 ausgebildet. Im vertieften Strukturbereich IIa sind dabei die tiefenversetzten Kontaktierungsstellen 38, 38.2 mit korrespondierenden Kontaktanschlüssen 52 zumindest eines MLCC-Keramikvielschicht-Chipkondensators 50, 50.2 elektrisch kontaktiert. Die tiefenversetzten Kontaktierungsstellen 38, 38.2 bzw. die Anschlussfläche 36.2a sind in vorliegendem Ausführungsbeispiel auf einem ersten und einem zweiten Stufenabsatz 37 ausgebildet, welche jeweils von einem Strukturareal 36.1 von der äußersten Abschlussfläche 35a abgesetzt sind und mit dem Anschlusshöhenmaß h2 abschließen. Die beiden zugewandten Spaltabsätze 37 sind über eine Spaltaussparung 39 elektrisch isoliert getrennt, wobei die Spaltaussparung 39 vom elektrisch kontaktierten MLCC-Keramikvielschicht-Chipkondensator 50, 50.2 überbrückt ist. Die tiefenversetzten Kontaktierungsstellen 38.2 weisen ein Fine-Pitch-Anschlussmaß f2 auf, welches den Anschlussmaßen von MLCC-Keramikvielschicht-Chipkondensatoren 50, 50.2 entspricht. Spiegelbildlich zu einer Mittelebene M des Trägersubstrates 20 ist bevorzugt identisch, zumindest im wesentlich ähnlich, ein weiterer vertiefter Strukturbereich IIb ausgebildet. Falls aus schaltungstechnischen Gründen für die Elektronikeinheit 100 erforderlich, kann in diesem vertieften Strukturbereich IIb ebenso zumindest ein weiterer MLCC-Keramikvielschicht-Chipkondensator 50, 50.2 vergleichbar wie im vertieften Strukturbereich IIa elektrisch kontaktiert sein.

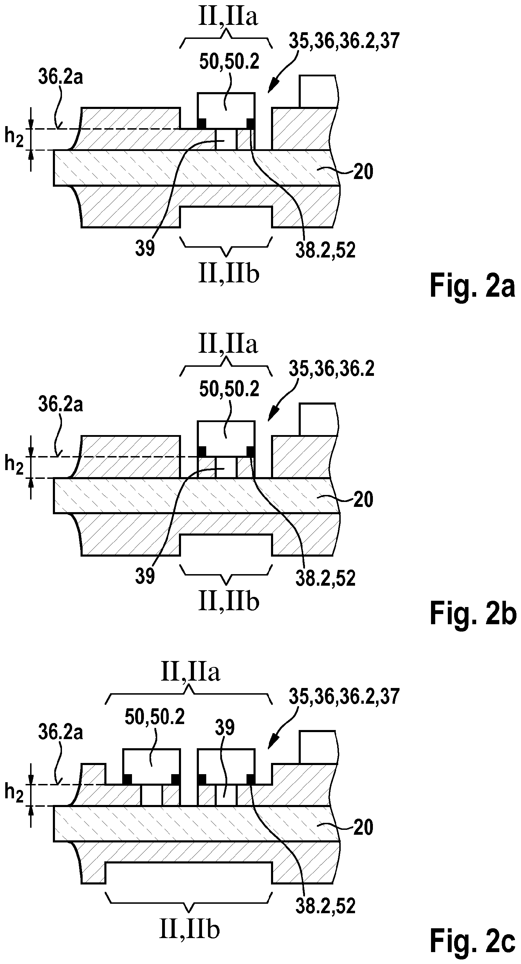

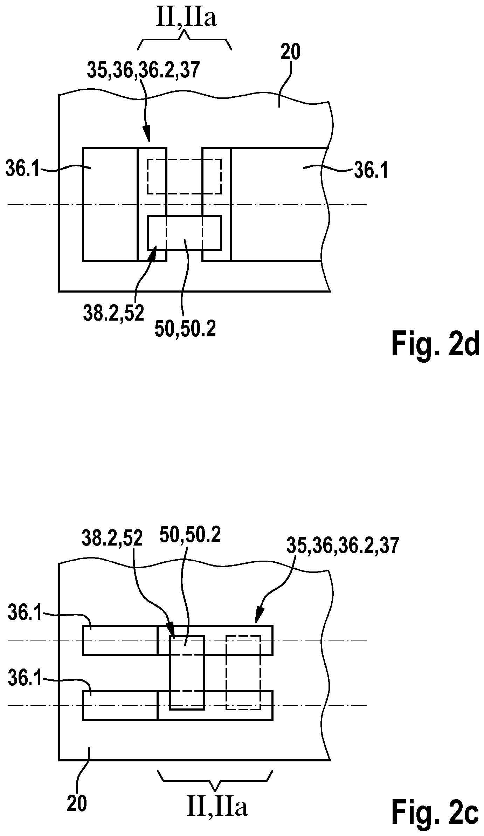

Die Ausbildung von vertieften Strukturbereichen IIa, IIb kann strukturell verschiedenartig ausgeführt sein. So zeigen die Fig. 2a - 2c Variationen in einer Seitenansicht und die Fig. 2d und 2e weitere Variationen in einer Draufsicht. Die Fig. 2a zeigt beispielsweise eine Ausführungsvariation eines vertieften Strukturbereiches II, welcher im Gegensatz zum Ausführungsbeispiel gemäß der Fig. 1 nur einen Stufenabsatz 37 umfassend eine Kontaktierungsstelle 38.2 für den MLCC-Keramikvielschicht-Chipkondensators 50, 50.2 aufweist. Zusätzlich ist zum Stufenabsatz 37 direkt benachbart ein Strukturareal 36.2 ausgebildet, welcher mit dem Anschlusshöhenmaß h2 abschließt und zumindest eine weitere Kontaktierungsstelle 38.2 für den MLCC-Keramikvielschicht-Chipkondensators 50, 50.2 auf einer Anschlussfläche 36.2a aufweist. Der gespiegelte vertiefte Strukturbereich IIb ist durch eine Nutaussparung lediglich ähnlich ausgebildet und weist beispielsweise keine Spaltaussparungen 39 auf, die bis zur Unterseite 20b des Trägersubstrates 20 reichen. Die Fig. 2b zeigt eine Ausführungsvariation, in welcher der vertiefte Strukturbereich IIa keinen Stufenabsatz 37 aufweist. Stattdessen sind zwei direkt benachbarte Strukturareale 36.2 mit dem Anschlusshöhenmaß h2 angeordnet. Diese weisen auf ihrer jeweiligen Anschlussfläche 36.2a Kontaktierungsstellen 38.2 für den elektrisch kontaktierten MLCC-Keramikvielschicht-Chipkondensator 50, 50.2 auf. Der gespiegelte vertiefte Strukturbereich IIb ist wie in der Fig. 2a nutartig ausgebildet, wobei die Nutbreite zusätzlich verkleinert oder alternativ vergrößert ist. In der Fig. 2c ist eine Ausführungsvariation gezeigt, bei welcher beispielsweise zwei MLCC-Keramikvielschicht-Chipkondensators 50, 50.2 kontaktiert sind. Die Kontaktierungsstellen 38.2 sind hierbei sowohl auf Stufenabsätzen 37 als auch auf Strukturarealen 36.2 mit dem Anschlusshöhenmaß h2 ausgebildet. Die hierbei gebildete Kontaktanordnung mit den MLCC-Keramikvielschicht-Chipkondensatoren 50, 50.2 entspricht einer gespiegelten Anordnung der in der Fig. 2a gezeigten Kontaktanordnung. Die Fig. 2d zeigt zwei direkt benachbarte in einer Linienanordnung angeordnete Strukturareale 36.1 mit jeweils einem Stufenabsatz 37, die zueinander zugewandt sind. Innerhalb des ausgebildeten vertieften Strukturbereiches IIa ist ein MLCC-Keramikvielschicht-Chipkondensators 50, 50.2 mit Kontaktierungsstellen 38.2 auf den Stufenabsätzen 37 elektrisch kontaktiert, wobei parallel versetzt weitere MLCC-Keramikvielschicht-Chipkondensatoren 50, 50.2 gleichsam kontaktiert sein können. Etwas abgewandelt zeigt die Fig. 2e die Strukturareale 36.1 aus Fig. 2d in einer Parallelanordnung und der Kontaktierungsmöglichkeit eines MLCC-Keramikvielschicht-Chipkondensators 50, 50.2.

Grundsätzlich können noch weitere Variationen ausgeführt werden, wobei auch solche denkbar sind, die zwei oder mehrere Ausführungen gemäß den Fig. 1, Fig. 2a - 2e miteinander kombinieren und/oder teilweise in Einzelaspekten sich ergänzen.

Allgemein ist im Strukturbereich I außerhalb der vertieften Strukturbereiche IIa, IIb eine Teilschaltung der elektronischen Schaltung 80 ausgebildet, die beispielsweise zumindest eine Leistungsschaltung 80.1 umfasst. Die Leistungsschaltung 80.1 weist dabei beispielsweise mindestens einen Leistungshalbleiter 50.1 auf, welcher beispielsweise mit weiteren zu einer Halbbrückenschaltung oder einer B6-Brückeschaltung über entsprechende Strukturareale 36.1 verschaltet ist. Innerhalb des vertieften Strukturbereiches IIa können neben einem oder mehreren MLCC-Keramikvielschicht-Chipkondensatoren 50, 50.2 noch weitere elektrische und/oder elektronische Bauelemente 50 mit zumindest einem Stufenabsatz 37 und/oder einem Strukturareal 36.2 mit dem Anschlusshöhenmaß h2 kontaktiert sein (nicht dargestellt). Dabei kann dann im vertieften Strukturbereich IIa zumindest eine Logik- und/oder Ansteuerschaltung 80.2, insbesondere für die Leistungsschaltung 80.1, als eine weitere Teilschaltung der elektronischen Schaltung 80 ausgebildet sein. Die Logik- und/oder Ansteuerschaltung 80.2 umfasst beispielsweise ein Logikbauelement, insbesondere ein IC (intergrated circuit), ein ASIC, ein Gate-treiber und/oder andere.

In den Fig. 3a bis 3c ist die Herstellung des keramischen Schaltungsträgers 10 zu verschiedenen Fertigungsphasen gezeigt, wobei hierzu rein beispielhaft die Ausführung am Schaltungsträger gemäß der Fig. 1 erläutert wird. Gemäß Fig. 3a wird hierbei auf einen AMB-Schaltungsträger als ein Ausgangssubstrat 10' zurückgegriffen. Das Ausgangssubstrat 10' weist dabei ein keramisches Trägersubstrat 20 auf, wobei auf den Oberflächenseiten 20a, 20b jeweils eine Abschlussfläche 35a ausgebildet ist, die durch Aufbringen zumindest einer flächig durchgehenden, geschlossenen Metallschicht oder Metallfolie 35", enthaltend Kupfer oder eine Kupferlegierung, mittels eines Aktiv-Lot-Verfahrens erzeugt sind. Die Metallschicht oder Metallfolie 35" weist dabei eine Schichtdicke h1 auf und ist in diesem Ausführungsbeispiel beidseitig gleich. Auf mindesten einer Oberflächenseite 20a, 20b des keramischen Trägersubstrates 20 wird gemäß Fig. 3b durch einen Ätzprozess eine erste Zwischenstufe einer Leiterstruktur 35' aus der ursprünglich durchgehenden, geschlossenen Metallschicht oder Metallfolie 35" ausgebildet. In diesem Verfahrensschritt wird bevorzugt bereits der Strukturbereich I ausgebildet, welcher eine Grobstruktur aufweist für bereits ausgebildete elektrisch isolierte Strukturareale 36.1. Hierbei wird durch einen gestuften Ätzprozess zeitgleich oder nachträglich auf jeder Oberflächenseite 20a, 20b des Trägersubstrates 20 jeweils zumindest eine Vertiefungsnut 37' eingebracht. Beide Vertiefungsnuten 37' sind zu einer Mittenebene M des Trägersubstrates 20 spiegelbildlich ausgebildet und weisen jeweils mindestens zwei Nutseitenflächen und einem Nutgrund auf, welcher mit der Anschlusshöhenmaß h2 abschließt. Die Anschlussfläche 36.2a im Nutgrund ist daher auf ein Höhenmaß reduziert, welches dem geforderten Höhenmaß h2 eines noch auszubildenden Strukturbereichs IIa, IIb entspricht. Alternativ kann die Vertiefungsnut 37' auch nur eine Nutseitenfläche aufweisen, um eine andere Ausführungsvariante eines vertieften Strukturbereiches IIa, IIb ausbilden zu können.

In einem nachfolgenden Verfahrensschritt wird dann die Endstufe der Leiterstruktur 35 ausgebildet, wie es in der Fig. 3c gezeigt ist. Hierfür wird beispielsweise mittels eines Lasers 60 ein Laserabtragungsprozess ausgeführt, durch welchen im Bereich der Vertiefungsnuten 37' Material bis zur Oberflächenseiten 20a, 20b des keramischen Trägersubstrates 20 abgetragen wird und mittels der dann ausgebildeten jeweils elektrisch trennenden Spaltaussparungen 39 die vertieften Strukturbereiche IIa, IIb fertiggestellt werden. Zur Einsparung von Prozessschritten kann auch die eine Spaltaussparung 39 auf Seiten der Unterseite 20b des Trägersubstrates 20 entfallen. Anstelle des Laserabtragungsprozesses kann alternativ die Spaltaussparung 39 auch durch einen weiteren Ätzprozess ausgebildet werden. In Hinblick auf die gezeigten Ausführungsvarianten gemäß den Fig. 2a - 2e und anderen kann durch den Laserabtragungsprozess oder den weiteren Ätzprozess gleichsam die entsprechenden Stufenabsätze 37 und/oder Strukturareale 36.2 mit dem Anschlusshöhenmaß h2 ausgebildet werden.

Anschließend werden korrespondierende Kontaktanschlüsse 52 von elektrischen und/oder elektronischen Bauelementen 50, 50.1, 50.2 mit den entsprechenden Kontaktierungsstellen 38, 38.1, 38.2 innerhalb und außerhalb der vertieften Strukturbereiche IIa, IIb unter Ausbildung der elektronischen Schaltung 80 der Elektronikeinheit 100 gemäß der Fig. 1 elektrisch kontaktiert, beispielsweise mittels einer Lot-, Sinter- oder Leitkleberverbindung.

## Patentansprüche

1. Elektronikeinheit (100) umfassend zumindest einen Schaltungsträger (10) mit einem keramischen Trägersubstrat (20) aus Si3N4, insbesondere ein AMB (Active Metal Brazing) -Schaltungsträger, wobei das Trägersubstrat (20) eine Ober- und eine Unterseite (20a, 20b) aufweist und auf der Ober- und/oder Unterseite (20a, 20b) zumindest eine Leiterstruktur (35) umfassend zumindest eine Schicht aus Kupfer oder einer Kupferlegierung angeordnet ist, wobei die Leiterstruktur (35) eine äußerste Abschlussfläche (35a) aufweist, auf welcher Kontaktierungsstellen (38, 38.1) ausgebildet sind, die mit Kontaktanschlüssen (52) zumindest eines elektrischen und/oder elektronischen Bauelements (50) unter Ausbildung einer elektronischen Schaltung (80) der Elektronikeinheit (100) elektrisch kontaktiert sind, und wobei die elektronische Schaltung (80) zumindest einen MLCC-Keramikvielschicht-Chipkondensator (Multi Layer Ceramic Capacitor) (50, 50.2) umfasst
**dadurch gekennzeichnet, dass**
die Leiterstruktur (35) zumindest einen gegenüber der äußersten Abschlussfläche (35a) vertieften Strukturbereich (II, IIa, IIb) aufweist, wobei in dem zumindest einen vertieften Strukturbereich (II, IIa, II) tiefenversetzte Kontaktierungsstellen (38, 38.2) ausgebildet sind, die mit korrespondierenden Kontaktanschlüssen (52) des zumindest einen MLCC-Keramikvielschicht-Chipkondensator (50, 50.2) elektrisch kontaktiert sind.

2. Elektronikeinheit (100) nach Anspruch 1,
**dadurch gekennzeichnet, dass**
das Trägersubstrat zwischen der Ober- und Unterseite (20a, 20b) eine Substratstärke von von 250 um bis einschließlich 635 um aufweist und/oder die äußerste Abschlussfläche (35a) der Leiterstruktur (35) in einem senkrechten Schnitt zur Ober- und/oder Unterseite (20a, 20b) mit einem Abschlusshöhenmaß (h1) von 300 um - 1000 um abschließt.

3. Elektronikeinheit (100) nach einem der Ansprüche 1 oder 2,
**dadurch gekennzeichnet, dass**
der zumindest eine vertiefte Strukturbereich (II, IIa, IIb) zumindest eine Anschlussfläche (36.2a) umfasst, auf der zumindest eine tiefenversetzte Kontaktierungsstelle (38, 38.2) ausgebildet ist, wobei die Anschlussfläche (36.2) in einem senkrechten Schnitt zur Ober- und/oder Unterseite (20a, 20b) mit einem Anschlusshöhenmaß (h2) von 100 µm bis einschließlich 800 µm abschließt, wobei bevorzugt das Anschlusshöhenmaß mindestens 50 um, bevorzugt mindestens 100 um kleiner ist als das Abschlusshöhenmaß h1.

4. Elektronikeinheit (100) nach einem der vorhergehenden Ansprüche,
**dadurch gekennzeichnet, dass**
die Leiterstruktur (35) zumindest gebildet ist aus mehreren direkt benachbarten und über das keramische Trägersubstrat elektrisch voneinander isolierten Strukturarealen (36, 36.1, 36.2), insbesondere in Form von Leiterbahnen und/oder Kontaktanschlusspads, wobei die zumindest eine Anschlussfläche (36.2a) in dem zumindest einen vertieften Strukturbereich (II, IIa, IIb) gebildet ist auf einem Stufenabsatz (37), welcher von einem Strukturareal (36.1) von der äußersten Abschlussfläche (35a) abgesetzt ist und mit dem Abschlusshöhenmaß (h2) abschließt und/oder auf zumindest einem Strukturareal (36.2) ausgebildet ist, welches mit einem Anschlusshöhenmaß (h2) abschließt.

5. Elektronikeinheit (100) nach Anspruch 4,
**dadurch gekennzeichnet, dass**
durch korrespondierende Kontaktanschlüsse (52) zumindest eines MLCC-Keramikvielschicht-Chipkondensator (50.2) und mit diesen elektrisch kontaktierten tiefenversetzten Kontaktierungsstellen (38.2) zumindest eine erste Art von Kontaktanordnung ausgebildet ist, bei welcher die tiefenversetzten Kontaktierungsstellen (38.2) auf zwei sich zugewandten direkt benachbarten Stufenabsätzen (37) ausgebildet sind oder eine zweite Art von Kontaktanordnung ausgebildet ist, bei welcher die tiefenversetzten Kontaktierungsstellen (38.2) auf einem Stufenabsatz (37) und einem direkt benachbarten Strukturareal (36.2) mit dem Anschlusshöhenmaß (h2) ausgebildet sind oder eine dritte Art von Kontaktanordnung gebildet ist, bei welcher tiefenversetzte Kontaktierungsstellen (38.2) auf zweien direkt benachbarten Strukturarealen (36.2) mit jeweils dem Anschlusshöhenmaß (h2) ausgebildet sind.

6. Elektronikeinheit (100) nach Anspruch 5,
**dadurch gekennzeichnet, dass**
bei zwei oder mehreren in einem vertieften Strukturbereich elektrisch kontaktierten MLCC-Keramikvielschicht-Chipkondensatoren (50.2) ausschließlich eine Art von Kontaktanordnung ausgebildet ist oder zumindest zwei unterschiedliche Arten von Kontaktanordnungen ausgebildet sind.

7. Elektronikeinheit (100) nach einem der Ansprüche 4 bis 6,
**dadurch gekennzeichnet, dass**
in einem vertieften Strukturbereich (II, IIa, IIb) neben dem zumindest einem MLCC-Keramikvielschicht-Chipkondensator (50.2) weitere elektrische und/oder elektronische Bauelemente (50) mit zumindest einem Stufenabsatz (37) und/oder mit zumindest einem Strukturareal (36.2) mit dem Anschlusshöhenmaß (h2) unter Ausbildung einer Ansteuerschaltung (80.2) für eine Leistungsschaltung (80.2) elektrisch kontaktiert sind, wobei die Leistungsschaltung (80.1) elektrische und/oder elektronische Bauelemente (50, 50.1) umfasst, die zumindest mit den Strukturarealen (36.1) mit dem Abschlusshöhenmaß (h1) elektrisch kontaktiert sind.

8. Elektronikeinheit (100) nach einem der vorhergehenden Ansprüche,
**dadurch gekennzeichnet, dass**
auf der Oberseite und der Unterseite (20a, 20b) jeweils zumindest ein vertiefter Strukturbereich (II, IIa, IIb) ausgebildet sind, die zu einer Mittelebene (M) des Trägersubstrats (20) gespiegelt identisch oder weitestgehend strukturell identisch ausgebildet sind.

9. Elektronikeinheit (100) nach dem Anspruch 8,
**dadurch gekennzeichnet, dass**
die gespiegelten vertieften Strukturbereiche (II, IIa, IIb) sich 80% -100%, insbesondere 90% - 100 %, in gleich ausgeführten Strukturteilen entsprechen.

10. Verfahren zur Ausbildung einer Elektronikeinheit (100) nach einem der Ansprüche 1 bis 9, mit den nachfolgenden Verfahrensschritten:
e) Bereitstellen eines keramischen Ausgangssubstrates (10') mit einem keramischen Trägersubstrat (20) aus Si3N4, wobei an wenigstens einer Oberflächenseite (20a, 20b) des keramischen Trägersubstrates (20) wenigstens eine durchgehend geschlossene metallische Abschlussfläche (35a) ausgebildet ist, die durch Aufbringen zumindest einer Metallschicht oder Metallfolie (35") aus Kupfer oder einer Kupferlegierung mittels Aktiv-Lot-Verfahrens erzeugt ist, insbesondere ein AMB-Schaltungsträger, wobei die Abschlussfläche (35a) mit dem Abschlusshöhenmaß (h1) abschließt,
f) Ausbilden einer Zwischenstufe der Leiterstruktur (35') in der Metallschicht oder Metallfolie (35") auf zumindest einer Oberflächenseite (20a, 20b) des Trägersubstrates (20) durch einen Ätzprozess, durch welchen zueinander beabstandete metallische Strukturareale (36, 36.1) mit dem Abschlusshöhenmaß (h1) ausgebildet werden, welche über das keramische Trägersubstrat (20) elektrisch voneinander isoliert sind, wobei dann mittels eines gestuften chemischen Ätzprozesses in zumindest einem Strukturareal (36, 36.1) eine zur Abschlussfläche (35a) abgesetzte Vertiefungsnut (37') ausgebildet wird, die eine oder zwei abstehende Nutseitenflächen und einen Nutgrund mit dem Anschlusshöhenmaß (h2) aufweist,
g) Ausbilden einer Endstufe der Leiterstruktur (35), umfassend zumindest einen vertieften Strukturbereich (II, IIa, IIb), indem mittels eines weiteren Ätzprozesses oder mittels eines Laserabtragungsprozesses im Bereich der Vertiefungsnut (37') metallisches Material der Metallschicht oder der Metallfolie (35") bis zur Oberflächenseite (20a, 20b) des keramischen Trägersubstrates (20) abgetragen wird, so dass zumindest ein Strukturareal (36.1) mit einem Stufenabsatz (37), insbesondere zwei Strukturareale (36.1) mit zueinander zugewandten Stufenabsätzen (37), und/oder zumindest ein Strukturareal (36.2) mit jeweils dem Anschlusshöhenmaß (h2) als der vertiefte Strukturbereich (II, IIa, IIb) ausgebildet werden,
h) Elektrisches Kontaktieren von korrespondierenden Anschlusskontakten (52) zumindest eines MLCC-Keramikvielschicht-Chipkondensators (50.2) mit zumindest einem Stufenabsatz (37) und/oder mit einem Strukturareal (36.2) mit jeweils dem Anschlusshöhenmaß (h2).

## Claims

1. Electronics unit (100) comprising at least one circuit carrier (10) with a ceramic carrier substrate (20) composed of Si3N4, in particular an AMB (Active Metal Brazing) circuit carrier, wherein the carrier substrate (20) has a top and a bottom side (20a, 20b) and at least one conductor structure (35) comprising at least one layer composed of copper or a copper alloy is arranged on the top and/or the bottom side (20a, 20b), wherein the conductor structure (35) has an outermost termination surface (35a) on which contact-making points (38, 38.1) are formed, which contact-making points are electrically contact-connected to contact connections (52) of at least one electrical and/or electronic component (50) so as to form an electronic circuit (80) of the electronics unit (100), and wherein the electronic circuit (80) comprises at least one MLCC ceramic multilayer chip capacitor (Multi Layer Ceramic Capacitor) (50, 50.2),
**characterized in that**
the conductor structure (35) has at least one structure region (II, IIa, IIb) which is recessed in relation to the outermost termination surface (35a), wherein countersunk contact-making points (38, 38.2) are formed in the at least one recessed structure region (II, IIa, II) and are electrically contact-connected to corresponding contact connections (52) of the at least one MLCC ceramic multilayer chip capacitor (50, 50.2).

2. Electronics unit (100) according to Claim 1,
**characterized in that**
the carrier substrate has, between the top and the bottom side (20a, 20b), a substrate thickness of from 250 µm up to and including 635 µm and/or the outermost termination surface (35a) of the conductor structure (35) terminates in a perpendicular section in relation to the top and/or the bottom side (20a, 20b) with a termination height (h1) of 300 µm - 1000 µm.

3. Electronics unit (100) according to either of Claims 1 and 2,
**characterized in that**
the at least one recessed structure region (II, IIa, IIb) comprises at least one connection surface (36.2a) on which at least one countersunk contact-making point (38, 38.2) is formed, wherein the connection surface (36.2) terminates in a perpendicular section in relation to the top and/or the bottom side (20a, 20b) with a connection height (h2) of from 100 µm up to and including 800 µm, wherein the connection height is preferably at least 50 µm, preferably at least 100 µm, smaller than the termination height h1.

4. Electronics unit (100) according to one of the preceding claims,
**characterized in that**
the conductor structure (35) is at least formed from a plurality of directly adjacent structure areas (36, 36.1, 36.2) which are electrically insulated from one another by means of the ceramic carrier substrate, in particular in the form of conductor tracks and/or contact connection pads, wherein the at least one connection surface (36.2a) in the at least one recessed structure region (II, IIa, IIb) is formed on a step (37) which is offset from a structure area (36.1) of the outermost termination surface (35a) and terminates with the termination height (h2) and/or is formed on at least one structure area (36.2) which terminates with a connection height (h2).

5. Electronics unit (100) according to Claim 4,
**characterized in that**,
by way of corresponding contact connections (52) of at least one MLCC ceramic multilayer chip capacitor (50.2) and countersunk contact-making points (38.2) which are electrically contact-connected to the said contact connections, at least one first type of contact arrangement is formed, in which the countersunk contact-making points (38.2) are formed on two facing, directly adjacent steps (37), or a second type of contact arrangement is formed, in which the countersunk contact-making points (38.2) are formed on a step (37) and a directly adjacent structure area (36.2) with the connection height (h2), or a third type of contact arrangement is formed, in which countersunk contact-making points (38.2) are formed on two directly adjacent structure areas (36.2) with in each case the connection height (h2).

6. Electronics unit (100) according to Claim 5,
**characterized in that**
only one type of contact arrangement is formed or at least two different types of contact arrangements are formed in two or more MLCC ceramic multilayer chip capacitors (50.2) which are electrically contact-connected in a recessed structure region.

7. Electronics unit (100) according to one of Claims 4 to 6,
**characterized in that**,
in a recessed structure region (II, IIa, IIb) next to the at least one MLCC ceramic multilayer chip capacitor (50.2), further electrical and/or electronic components (50) are electrically contact-connected to at least one step (37) and/or to at least one structure area (36.2) with the connection height (h2) so as to form a drive circuit (80.2) for a power circuit (80.2), wherein the power circuit (80.1) comprises electrical and/or electronic components (50, 50.1) which are electrically contact-connected at least to the structure areas (36.1) with the termination height (h1).

8. Electronics unit (100) according to one of the preceding claims,
**characterized in that**
at least one recessed structure region (II, IIa, IIb) is formed on the top side and the bottom side (20a, 20b) in each case, which recessed structure regions are of identical or largely structurally identical design in mirror image with respect to a centre plane (M) of the carrier substrate (20).

9. Electronics unit (100) according to Claim 8,
**characterized in that**
the mirror-image recessed structure regions (II, IIa, IIb) correspond by 80%-100%, in particular 90%-100%, in terms of structural parts of the same design.

10. Method for forming an electronics unit (100) according to one of Claims 1 to 9, comprising the following method steps:
e) providing a ceramic starting substrate (10') with a ceramic carrier substrate (20) composed of Si3N4, wherein at least one continuously closed metallic termination surface (35a) is formed on at least one surface side (20a, 20b) of the ceramic carrier substrate (20), which termination surface is produced by applying at least one metal layer or metal foil (35") composed of copper or a copper alloy by means of an active soldering method, in particular an AMB circuit carrier, wherein the termination surface (35a) terminates with the termination height (h1),
f) forming an intermediate stage of the conductor structure (35') in the metal layer or metal foil (35") on at least one surface side (20a, 20b) of the carrier substrate (20) by an etching process by way of which metallic structure areas (36, 36.1) which are spaced apart from one another and have the termination height (h1) and are electrically insulated from one another by means of the ceramic carrier substrate (20) are formed, wherein a recess groove (37') which is offset in relation to the termination surface (35a) and has one or two projecting groove side faces and a groove base with the connection height (h2) is then formed in at least one structure area (36, 36.1) by means of a stepped chemical etching process,
g) forming an end stage of the conductor structure (35), comprising a recessed structure region (II, IIa, IIb), by way of metallic material of the metal layer or of the metal foil (35") being removed down to the surface side (20a, 20b) of the ceramic carrier substrate (20) by means of a further etching process or by means of a laser removal process in the region of the recess groove (37'), so that at least one structure area (36.1) with a step (37), in particular two structure areas (36.1) with steps (37) which face one another, and/or at least one structure area (36.2) with in each case the connection height (h2) are/is formed as the recessed structure region (II, IIa, IIb),
h) electrically contact-connecting corresponding connection contacts (52) of at least one MLCC multilayer chip capacitor (50.2) to at least one step (37) and/or to at least one structure area (36.2) with in each case the connection height (h2).

## Revendications

1. Unité électronique (100), comprenant au moins un support de circuit (10) doté d'un substrat de support en céramique (20) en Si3N4, en particulier un support de circuit AMB (« Active Metal Brazing »), dans laquelle le substrat de support (20) présente une face supérieure et une face inférieure (20a, 20b), et sur la face supérieure et/ou la face inférieure (20a, 20b), au moins une structure conductrice (35) comprenant au moins une couche de cuivre ou d'un alliage de cuivre est disposée, la structure conductrice (35) présentant une surface terminale la plus à l'extérieur (35a) sur laquelle sont réalisés des points de mise en contact (38, 38.1) qui sont mis en contact électrique avec des bornes de contact (52) d'au moins un composant électrique et/ou électronique (50) en réalisant un circuit électronique (80) de l'unité électronique (100), et le circuit électronique (80) comprenant au moins un condensateur à puce céramique multicouche MLCC (« Multi Layer Ceramic Capacitor ») (50, 50.2),
**caractérisée en ce que** la structure conductrice (35) présente au moins une zone de structure (II, IIa, IIb) évidée par rapport à la surface terminale la plus à l'extérieur (35a), dans laquelle, dans ladite au moins une zone de structure évidée (II, IIa, II) des points de mise en contact (38, 38.2) décalés en profondeur sont réalisés, qui sont mis en contact électrique avec des bornes de contact (52) correspondantes de l'au moins un condensateur à puce céramique multicouche MLCC (50, 50.2).

2. Unité électronique (100) selon la revendication 1,
**caractérisée en ce que** le substrat de support présente entre la face supérieure et la face inférieure (20a, 20b) une épaisseur de substrat de 250 µm à 635 µm inclus, et/ou la surface terminale la plus à l'extérieur (35a) de la structure conductrice (35) se termine par une coupe verticale par rapport à la face supérieure et/ou à la face inférieure (20a, 20b) ayant une hauteur terminale (h1) de 300 µm à 1000 µm.

3. Unité électronique (100) selon l'une quelconque des revendications 1 et 2, **caractérisée en ce que** ladite au moins une zone de structure évidée (II, IIa, IIb) comprend au moins une surface de connexion (36.2a) sur laquelle est réalisé au moins un point de mise en contact (38, 38.2) décalé en profondeur, la surface de connexion (36.2) se terminant par une coupe verticale par rapport à la face supérieure et/ou à la face inférieure (20a, 20b) ayant une hauteur de connexion (h2) de 100 µm à 800 µm inclus, la hauteur de connexion étant inférieure à la hauteur terminale h1 de préférence d'au moins 50 µm, de préférence d'au moins 100 µm.

4. Unité électronique (100) selon l'une quelconque des revendications précédentes, **caractérisée en ce que** la structure conductrice (35) est au moins formée à partir de plusieurs superficies de structure (36, 36.1, 36.2) directement voisines et isolées électriquement les unes par rapport aux autres par l'intermédiaire du substrat de support en céramique, en particulier sous la forme de pistes conductives et/ou de plages de bornes de contact, ladite au moins une surface de connexion (36.2a) étant formée dans ladite au moins une zone de structure évidée (II, IIa, IIb) sur un palier (37) qui est décalé par rapport à une superficie de structure (36.1) de la surface terminale la plus à l'extérieur (35a) et se termine à la hauteur terminale (h2), et/ou est réalisé sur au moins une superficie de structure (36.2) qui se termine à une hauteur de connexion (h2).

5. Unité électronique (100) selon la revendication 4,
**caractérisée en ce que** des bornes de contact (52) correspondantes d'un condensateur à puce céramique multicouche MLCC (50.2) et des points de mise en contact (38.2) décalés en profondeur et en contact électrique avec celles-ci réalisent au moins un premier type d'agencement de contact dans lequel les points de mise en contact (38.2) décalés en profondeur sont réalisés sur deux paliers (37) directement voisins, tournés l'un vers l'autre, ou réalisent un deuxième type d'agencement de contact dans lequel les points de mise en contact (38.2) décalés en profondeur sont réalisés sur un palier (37) et une superficie de structure (36.2) directement voisine ayant une hauteur de connexion (h2), ou forment un troisième type d'agencement de contact dans lequel des points de mise en contact (38.2) décalés en profondeur sont réalisés sur deux superficies de structure directement voisines (36.2) ayant respectivement la hauteur de connexion (h2) .

6. Unité électronique (100) selon la revendication 5,
**caractérisée en ce que** pour deux ou plusieurs condensateurs à puce céramiques multicouches MLCC (50.2), mis en contact électrique dans une zone de structure évidée, un seul type d'agencement de contact est réalisé, ou au moins deux types différents d'agencements de contact sont réalisés.

7. Unité électronique (100) selon l'une quelconque des revendications 4 à 6, **caractérisée en ce que** dans une zone de structure évidée (II, IIa, IIb) à côté de l'au moins un condensateur à puce céramique multicouche MLCC (50.2), d'autres composants électriques et/ou électroniques (50) sont mis en contact électrique avec au moins un palier (37) et/ou avec au moins une superficie de structure (36.2) ayant la hauteur de connexion (h2) en réalisant un circuit de pilotage (80.2) pour un circuit de puissance (80.2), le circuit de puissance (80.1) comprenant des composants électriques et/ou électroniques (50, 50.1) qui sont mis en contact électrique au moins avec les superficies de structure (36.1) ayant la hauteur terminale (h1).

8. Unité électronique (100) selon l'une quelconque des revendications précédentes, **caractérisée en ce que** sur la face supérieure et la face inférieure (20a, 20b) respectivement au moins une zone de structure évidée (II, IIa, IIb) est réalisée, lesdites zones étant réalisées en symétrie miroir par rapport à un plan central (M) du substrat de support (20) ou en grande partie de manière structurellement identique.

9. Unité électronique (100) selon la revendication 8,
**caractérisée en ce que** les zones de structure évidées (II, IIa, IIb) en symétrie miroir se correspondent à 80 % à 100 %, en particulier à 90 % à 100 %, en pièces structurelles réalisées de façon identique.

10. Procédé de réalisation d'une unité électronique (100) selon l'une quelconque des revendications 1 à 9, comprenant les étapes de procédé suivantes consistant à :
e) fournir un substrat de départ en céramique (10') doté d'un substrat de support en céramique (20) en Si3N4, dans lequel, sur au moins un côté de surface (20a, 20b) du substrat de support en céramique (20) est réalisée au moins une surface terminale métallique (35a) complètement fermée qui est créée par l'application d'au moins une couche métallique ou d'un film métallique (35") en cuivre ou en alliage de cuivre au moyen d'un procédé de brasage actif, en particulier un support de circuit AMB, la surface terminale (35a) se terminant à la hauteur terminale (h1),
f) réaliser un niveau intermédiaire de la structure conductrice (35') dans la couche métallique ou le film métallique (35") sur au moins un côté de surface (20a, 20b) du substrat de support (20) par un procédé de gravure par lequel des superficies de structure métalliques mutuellement espacées (36, 36.1) ayant la hauteur terminale (h1) sont réalisées qui sont isolées électriquement les unes des autres par l'intermédiaire du substrat de support en céramique (20), dans lequel ensuite, au moyen d'un processus de gravure chimique gradué, dans au moins une superficie de structure (36, 36.1), une rainure en creux (37'), décalée par rapport à la surface terminale (35a) est réalisée qui présente une ou deux surfaces latérales de rainure et un fond de rainure ayant une hauteur de connexion (h2),
g) réaliser un niveau d'extrémité de la structure conductrice (35), comprenant au moins une zone de structure évidée (II, IIa, IIb) en ce qu'au moyen d'un autre processus de gravure, ou au moyen d'un processus d'ablation laser, au niveau de la rainure en creux (37'), un matériau métallique de la couche métallique ou du film métallique (35") est enlevé jusqu'au côté de surface (20a, 20b) du substrat de support en céramique (20) de sorte qu'au moins une superficie de structure (36.1) dotée d'un palier (37), en particulier deux superficies de structure (36.1) dotées de paliers (37) tournés l'un vers l'autre, et/ou au moins une superficie de structure (36.2) ayant respectivement la hauteur de connexion (h2) sont réalisées en tant que zone de structure évidée (II, IIa, IIb),
h) mettre en contact électrique des contacts de connexion (52) correspondants d'au moins un condensateur à puce céramique multicouche MLCC (50.2) avec au moins un palier (37) et/ou une superficie de structure (36.2) ayant respectivement la hauteur de connexion (h2).
